(19) **Europäisches Patentamt / European Patent Office / Office européen des brevets**

(11) **EP 1 647 967 B1**

(12) **EUROPEAN PATENT SPECIFICATION**

(45) Date of publication and mention
of the grant of the patent:
**16.07.2008 Bulletin 2008/29**

(51) Int Cl.:
***G09G 3/32*** *(2006.01)*

(21) Application number: **05109386.2**

(22) Date of filing: **10.10.2005**

(54) **Organic light emitting display**

Organische lichtemittierende Anzeigevorrichtung

Dispositif d'affichage électroluminescent organique

(84) Designated Contracting States:
**DE FR GB**

(30) Priority: **13.10.2004 KR 2004081811**
**13.10.2004 KR 2004081812**

(43) Date of publication of application:
**19.04.2006 Bulletin 2006/16**

(73) Proprietor: **Samsung SDI Co., Ltd.**
**Suwon-si**
**Gyeonggi-do (KR)**

(72) Inventors:
• **Kim, Yang Wa**
**Legal & IP Team**
**Kiheung-eup**
**Yongin**
**Kyeonggi-do (KR)**

• **Oh, Choon Yul**
**Legal & IP Team**
**Kiheung-eup**
**Yongin**
**Kyeonggi-do (KR)**

(74) Representative: **Hengelhaupt, Jürgen et al**
**Anwaltskanzlei**
**Gulde Hengelhaupt Ziebig & Schneider**
**Wallstrasse 58/59**
**10179 Berlin (DE)**

(56) References cited:
**EP-A- 1 347 436        US-A1- 2003 059 525**
**US-A1- 2003 107 537        US-B1- 6 448 718**
**US-B1- 6 583 577**

**Description**

**BACKGROUND OF THE INVENTION**

**1. Field of the Invention**

The present invention relates to an organic light emitting display, and more particularly, to an organic light emitting display, in which the number of output lines provided in a data driver is decreased while the image is displayed with uniform brightness.

**2. Discussion of Related Art**

Recently, various flat panel displays have been developed, which are substituting for a cathode ray tube (CRT) display because the CRT display is relatively heavy and bulky. The flat panel displays include liquid crystal displays (LCD), field emission displays (FED), plasma display panels (PDP), and organic light emitting displays among other types.
Among the flat panel displays, the organic light emitting display includes organic light emitting diodes that emit light by electron-hole recombination. These organic light emitting displays have a faster response time than the LCDs that require a separate light source.

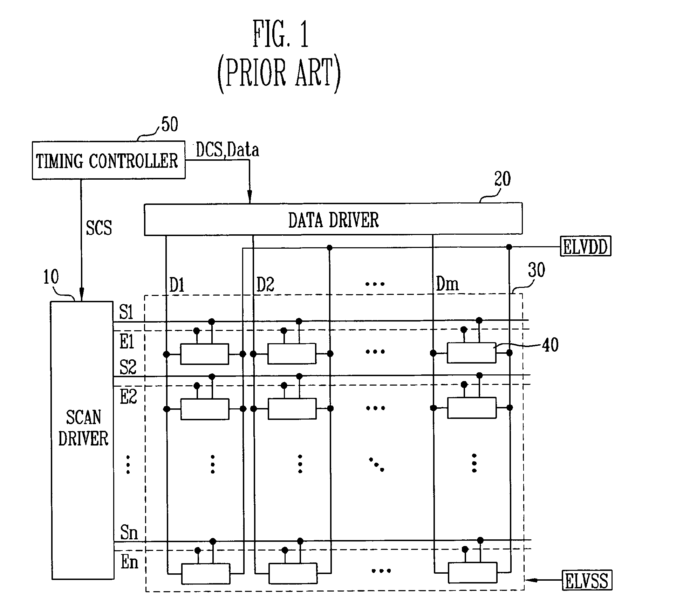

FIG. 1 illustrates a conventional organic light emitting display. A conventional organic light emitting display includes a pixel portion 30 including a plurality of pixels 40 formed in an intersection region of a plurality of scan lines S1 through Sn and a plurality of data lines D1 through Dm. A conventional organic light emitting display also includes a scan driver 10 to drive the scan lines S1 through Sn; a data driver 20 to drive the data lines D1 through Dm; and a timing controller 50 to control the scan driver 10 and the data driver 20.
The scan driver 10 generates scan signals in response to scan control signals SCS transmitted from the timing controller 50, and supplies the scan signals to the scan lines S1 through Sn in sequence. Further, the scan driver 10 generates emission control signals in response to the scan control signals SCS, and supplies the emission control signals to emission control lines E1 through En in sequence.
The data driver 20 generates data signals in response to data control signals DCS transmitted from the timing controller 50, and supplies the data signals to the data lines D1 through Dm. The data driver 20 supplies the data signal corresponding to one horizontal line per horizontal period to the data lines D1 through Dm.
The timing controller 50 generates the data control signals DCS and the scan control signals SCS in response to external synchronization signals. The data control signal DCS is transmitted to the data driver 20, and the scan control signal SCS is transmitted to the scan driver 10. Further, the timing controller 50 rearranges external data Data and supplies it to the data driver 20.
The pixel portion 30 receives external first power from an external first power source line ELVDD and external second power from an external second power source line ELVSS. The first power from the first power source line ELVDD and the second power from the second power source line ELVSS are supplied to each pixel 40. Each pixel 40 receives the data signal and displays an image corresponding to the data signal. Further, the emission time of the pixels 40 is controlled by the emission control signals.
In the conventional organic light emitting display, the pixels 40 are placed in the intersection regions of the scan lines S1 through Sn and the data lines D1 through Dm. The data driver 20 includes m output lines to supply the data signals to m data lines D1 through Dm. That is, the data driver 20 of the conventional organic light emitting display should have the same number of output lines as the number of the data lines D1 through Dm. To have m output lines, the data driver 20 needs to include a plurality of data integrated circuits that increase the production cost. Particularly, as the resolution and the size of the pixel portion 30 increase, the number of output lines of the data driver 20 increases. Thus, the production cost of the organic light emitting display is increased.
Therefore, there is a need for organic light emitting displays that require fewer output lines and therefore fewer data integrated circuits in their data driver. US 6,448,718 B1 discloses an active matrix electroluminescent display device having demultiplexers connected to the output lines of the data driver. Each demultiplexer receives data from an output line in a time-divisional manner and provides the data to a corresponding one of a plurality of demultiplexer outputs. Thus, the number of output pins of the data driver is reduced.
There is also a need for an organic light emitting display that displays a stable image with high uniformity.

**SUMMARY OF THE INVENTION**

Accordingly, it is an aspect of the present invention to provide an organic light emitting display, in which the number of output lines provided in a data driver is decreased, and an image is displayed with uniform brightness. The foregoing and/or other aspects of the present invention are achieved by providing an organic light emitting display comprising a scan driver, a data driver, a plurality of demultiplexers, a first power source line, and a pixel portion. The scan driver is adapted to supply scan signals to a plurality of scan lines. The data driver is adapted to supply data signals to a plurality of output lines. The demultiplexers are provided on each output line to supply the data signals to a plurality of data lines. The first power source line supplies first power through a first side of a plurality of pixel power source lines. The pixel portion comprises a plurality of first pixels and a plurality of second pixels. The first pixels are coupled to one of the plurality of scan lines, a first data line of the plurality of data lines, and one of the plurality of pixel power source lines. Each first pixel comprises a corresponding first one of a plurality of first capacitors adapted to receive a data signal from the first data line and a corresponding one of a plurality of first organic light emitting diodes having a first emission efficiency. Each first pixel is adapted to emit light corresponding to a data signal capacitively stored in the corresponding one of the first capacitors. The plurality of second pixels is coupled to one of the plurality of scan lines, a second data line of the plurality of data lines, and one of the plurality of pixel power source lines. Each second pixel comprises a corresponding second one of the plurality of first capacitors adapted to receive a data signal from the second data line and a corresponding one of a plurality of second organic light emitting diodes having a second emission efficiency lower than the first emission efficiency. Each second pixel being adapted to emit light corresponding to a data signal capacitively stored in the corresponding second one of the first capacitors. A plurality of second capacitors is formed to have different capacitances corresponding to overlapping areas between the first power source line and the respective data lines. Each second capacitor is capable of storing voltage corresponding to a data signal and supplying the stored voltage to the pixels. According to the invention, a first one of the plurality of second capacitors connected to the first data line has a first capacitance and a second one of the plurality of second capacitors connected to the second data line has a second capacitance smaller than the first capacitance.

## BRIEF DESCRIPTION OF THE DRAWINGS

FIG. 1 illustrates a conventional organic light emitting display.
FIG. 2 illustrates an organic light emitting display according to an embodiment of the present invention.
FIG. 3 illustrates waveforms of driving signals supplied to a scan line, a data line and the demultiplexer of FIG. 2.
FIG. 4 is a circuit diagram of a demultiplexer illustrated in FIG. 2.
FIG. 5 is a circuit diagram of a pixel illustrated in FIG. 2.
FIG. 6 is a circuit diagram illustrating coupling of the demultiplexer circuit of FIG. 4 to the pixel circuit of FIG. 5.
FIG. 7 illustrates a first layout of the organic light emitting display according to embodiments of the present invention.
FIG. 8 is an enlarged view of a first embodiment of portion "A" of the first layout shown in FIG. 7.
FIG. 9 is an enlarged view of a second embodiment of portion "A" of the first layout shown in FIG. 7.
FIG. 10 illustrates a second layout of the organic light emitting display according to embodiments of the present invention.
FIG. 11 is an enlarged view showing a first embodiment of portion "B" of the second layout shown in FIG. 10.
FIG. 12 is an enlarged view showing a second embodiment of portion "B" of the second layout shown in FIG. 10.
FIG. 13 is an enlarged view showing a third embodiment of portion "B" of the second layout shown in FIG. 10.
FIG. 14 illustrates a third layout of the organic light emitting display according to embodiments of the present invention.

## DETAILED DESCRIPTION

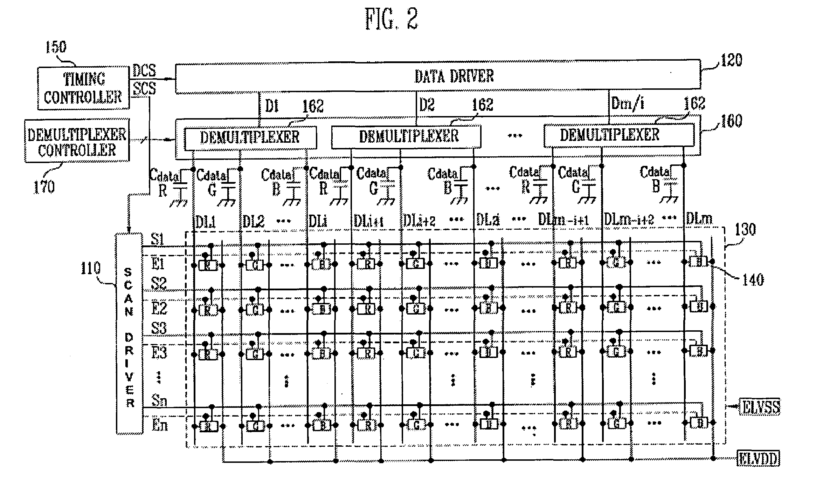

FIG. 2 illustrates an organic light emitting display according to an embodiment of the present invention.
The organic light emitting display includes a scan driver 110, a data driver 120, a pixel portion 130, a timing controller 150, a demultiplexer block 160, a demultiplexer controller 170, and data capacitors Cdata.
The pixel portion 130 includes a plurality of pixels 140 placed adjacent to regions defined by a plurality of scan lines S1 through Sn and a plurality of second data lines DL1 through DLm. Each pixel 140 emits light corresponding to a data signal transmitted through the second data line DL. The demultiplexer block 160 includes demultiplexers 162.

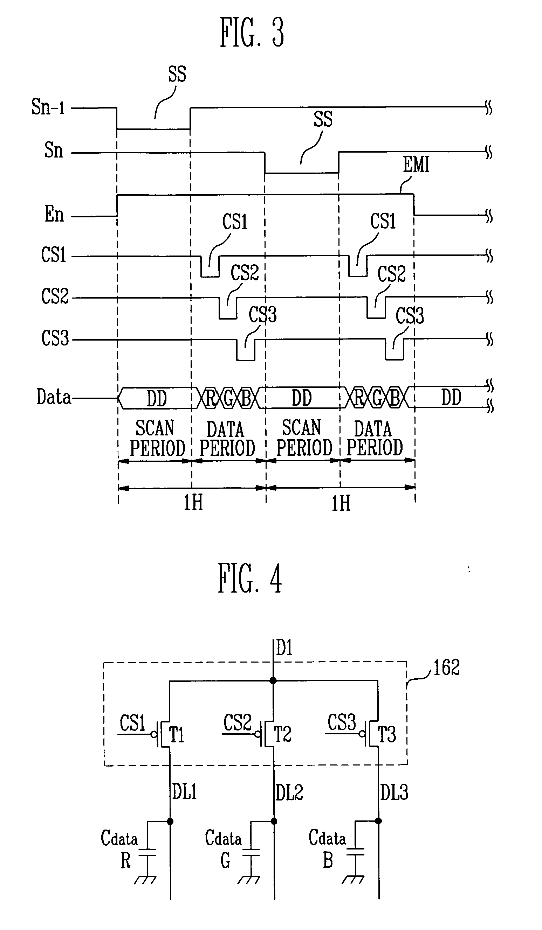

FIG. 3 illustrates waveforms of driving signals supplied to the scan lines, the data lines, and the demultiplexers of FIG. 2. The figure shows scan signals SS applied to the $n^{th}$ scan line Sn and the $(n-1)^{th}$ scan line Sn-1, emission control signals EMI applied to the emission control lines En, first, second, and third control signals CS1, CS2, CS3, and external data Data signals. The first, second, and third control signals CS1, CS2, CS3 are provided from the demultiplexer controller 170 to the pixels 140. Different parts of FIG. 3 pertain to various of the following figures and are discussed below together with the discussion of the pertinent figure. Further, the low or high position of the signals of FIG. 3 correspond to the transistor types of the circuits being driven by these signals. The circuits that are shown in the following figures may be implemented in NMOS as well as PMOS. Therefore, it is understood that driving signals of polarity opposite those shown would apply if the transistor type is changed.

The scan driver 110 generates scan signals SS in response to scan control signals SCS supplied from the timing controller 150, and supplies the scan signals SS to the scan lines S1 through Sn in sequence. The scan driver 110 supplies the scan signal SS during a predetermined period included in the one horizontal period 1H. For example, in one embodiment shown in FIG. 3, the one horizontal period 1H is divided into a scan period (first period) and a data period (second period). The scan driver 110 supplies the scan signal SS to the scan lines S1 through Sn during the scan period of the one horizontal period 1H. On the other hand, the scan driver 110 does not supply the scan signal SS during the data period of the one horizontal period 1H. The scan driver 110 also generates the emission control signals EMI in response to the scan control signals SCS, and supplies the emission control signals EMI to emission control lines E1 through En in sequence.

The data driver 120 generates the data signal in response to a data control signal DCS supplied from the timing controller 150, and supplies the data signals to a plurality of first data lines D1 through Dm/i. The data driver 120 supplies i data signals (where i is a natural number of 2 or more) to the first data lines D1 through Dm/i that are coupled to output lines of the data driver 120 in sequence.

For example, the data driver 120 supplies data signals R, G, B to the pixels 140 in sequence during the data period of the one horizontal period 1H. The data signals R, G, B are supplied during only the data period, so that supplying the data signals R, G, B does not overlap with supplying the scan signal SS. During the scan period of the one horizontal period 1H, the data driver 120 supplies a merely dummy data signal DD.

The timing controller 150 generates the data control signals DCS and the scan control signals SCS corresponding to external synchronization signals. The data control signals DCS generated by the timing controller 150 are supplied to the data driver 120, and the scan control signals SCS generated by the timing controller 150 are supplied to the scan driver 110.

The demultiplexer block 160 includes m/i demultiplexers 162. In other words, the demultiplexer block 160 has the same number of demultiplexers 162 as the number of the first data lines D1 through Dm/i. The demultiplexers 162 are coupled to the first data lines D1 through Dm/i, respectively. The demultiplexers 162 are also coupled to i second data lines DL1 through DLm, respectively. Thus, each demultiplexer 162 supplies the i data signals R, G, B received through each first data lines D, from the data driver 120 during the data periods, to the i second data lines DL.

Accordingly, as the data signal R, G, B received through one first data line D is supplied to i second data lines DL, the number of output lines required in the data driver 120 is markedly decreased. For instance, when i is 3, the number of output lines provided in the data driver 120 is decreased to 1/3 of the number of output lines required with no demultiplexing (i of one). Thus, the number of data integrated circuits provided in the data driver 120 is decreased. Employing the demultiplexer 162 for supplying the data signal R, G, B of one first data line D to i second data lines DL, helps reduce the production cost of the organic light emitting display.

The demultiplexer controller 170 supplies i control signals to the respective demultiplexers 162 during the data period in the one horizontal period 1H, thereby splitting the data signal from one of the first data lines D into i data signals and supplying i data signals to i second data lines DL. As shown in FIG. 3, the demultiplexer controller 170 supplies the i control signals in sequence, so that the i control signals do not overlap. In the exemplary embodiment shown in FIG. 2, the demultiplexer controller 170 is separately provided outside the timing controller 150. However, the invention is not limited to this configuration and the demultiplexer controller 170 may be integrally provided inside the timing controller 150.

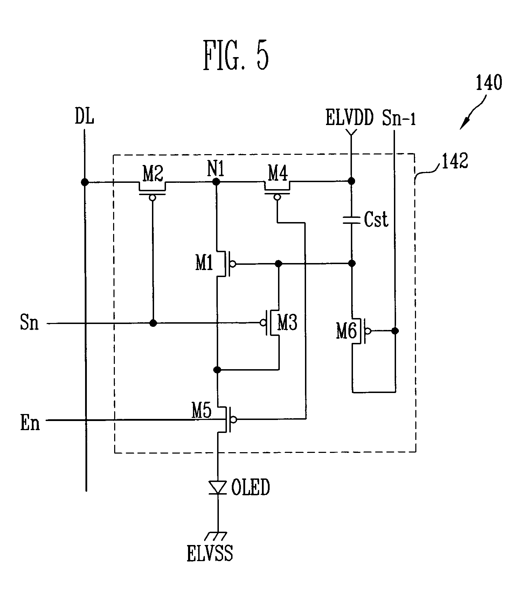

One data capacitor Cdata is provided in every second data line DL. The data capacitor Cdata temporarily stores the data signal R, G, B supplied to the second data line DL, and subsequently supplies the stored data signal R, G, B to the pixel 140. In one embodiment, the data capacitor Cdata is a parasitic capacitor equivalently formed by the second data line DL. In one embodiment, the capacitance of the parasitic capacitor equivalently formed by the second data line DL is larger than the capacitance of a storage capacitor Cst provided in every pixel 140 (refer to FIG. 5). This relationship between the two capacitance values causes stable storing of the data signal R, G, B in the storage capacitance Cst of the pixel 140.

FIG. 4 is a circuit diagram of the demultiplexer 162 illustrated in FIG. 2. In this figure, for the sake of convenience, i is 3 and the demultiplexer 162 is coupled to the 1st one of the first data lines D1.

Each demultiplexer 162 includes a first switching device T1, a second switching device T2, and a third switching device T3. The switching devices may be transistors.

The first switching device T1 is coupled between the 1st first data line D1 and the 1st second data line DL1. The first switching device T1 is turned on when it receives the first control signal CS1 from the demultiplexer controller 170, and supplies the data signal R, G, B from the 1st first data line D1 to the 1st second data line DL1. The data signal R, G, B supplied to the 1st second data line DL1 is temporarily stored in the first data capacitor Cdata1.

The second switching device T2 is coupled between the 1st first data line D1 and the 2nd second data line DL2. The second switching device T2 is turned on when it receives the second control signal CS2 from the demultiplexer controller 170, and supplies the data signal from the 1st first data line D1 to the 2nd second data line DL2. The data signal supplied to the 2nd second data line DL2 is temporarily stored in the second data capacitor Cdata2.

The third switching device T3 is coupled between the 1st first data line D1 and the 3rd second data line DL3. The third switching device T3 is turned on when it receives the third control signal CS3 from the demultiplexer controller 170, and supplies the data signal from the 1st first data line D1 to the 3rd second data line DL3. The data signal supplied to the 3rd second data line DL3 is temporarily stored in the third data capacitor Cdata3.

Operation of the demultiplexer 162 with the pixel 140 are described in the context of the exemplary circuit configurations of FIGs. 4 and 5.

FIG. 5 is a circuit diagram of the pixel 140 illustrated in FIG. 2. The pixel 140 of the invention is not limited to the circuit shown in FIG. 5, and may include other configurations. For example, the circuit may include at least one transistor capable of being used as a diode.

Each pixel 140 includes a pixel circuit 142 coupled to the second data line DL, the scan line Sn, the emission control line En, and an organic light emitting diode OLED. The pixel circuit 142 controls the organic light emitting diode OLED and causes it to emit light.

The organic light emitting diode OLED includes an anode electrode coupled to the pixel circuit 142, and a cathode electrode coupled to the second power source line ELVSS. The second power source line ELVSS applies a voltage lower than the voltage of the first power source line ELVDD. For example, the second power source line ELVSS may be at ground voltage. The organic light emitting diode OLED includes fluorescent and/or phosphorescent organic material that allow it to emit light when receiving a current supplied from the pixel circuit 142.

The pixel circuit 142 includes a storage capacitor Cst and first, second, thrid, fourth, fifth, and sixth transistors M1, M2, M3, M4, M5, M6. The storage capacitor Cst and the sixth transistor M6 are coupled between the first power source line ELVDD and the (n-1)th scan line Sn-1. The second transistor M2 and the fourth transistor M4 are coupled together forming a first node N1 and are also coupled between the first power source line ELVDD and the second data line DL. The fifth transistor M5 is coupled between the organic light emitting diode OLED and the emission control line En. The first transistor M1 is coupled between the fifth transistor M5 and the first node N1. The third transistor M3 is coupled between gate and drain terminals of the first transistor M1. In the exemplary embodiment shown in FIG. 5, the first through sixth transistors M1 through M6 are of a p-type metal oxide semiconductor field effect transistor (PMOSFET), but the invention is not limited to this particular exemplary configuration. Alternatively, the first through sixth transistors M1 through M6 may be of an n-type metal oxide semiconductor field effect transistor (NMOSFET). As well known to those skilled in the art, in the case where the first through sixth transistors M1 through M6 are of the NMOSFET type, polarity of driving waveforms is reversed.

The first transistor M1 includes a source terminal coupled to the first node N1, the drain terminal coupled to a source terminal of the fifth transistor M5, and the gate terminal coupled to the storage capacitor Cst. Further, the first transistor M1 supplies current corresponding to voltage charged in the storage capacitor Cst to the organic light emitting diode OLED.

The third transistor M3 includes a drain terminal coupled to the gate terminal of the first transistor M1, a source terminal coupled to the drain terminal of the first transistor M1, and a gate terminal coupled to the nth scan line Sn. The third transistor M3 is turned on when the scan signal SS is transmitted to the nth scan line Sn, and thus causes the first transistor M1 to be coupled like a diode. That is, when the third transistor M3 is turned on, the first transistor M1 functions as a diode.

The second transistor M2 includes a source terminal coupled to the second data line DL, a drain terminal coupled to the first node N1, and a gate terminal coupled to the nth scan line Sn. The second transistor M2 is turned on when the scan signal SS is transmitted to the nth scan line Sn. A turned-on second transistor M2 transmits the data signal R, G, B from the second data line DL to the first node N1.

The fourth transistor M4 includes a drain terminal coupled to the first node N1, a source terminal coupled to the first power source line ELVDD, and a gate terminal coupled to the emission control line En. The fourth transistor M4 is turned on when the emission control signal EMI is not being supplied. A turned-on fourth transistor electrically couples the first power source line ELVDD with the first node N1.

The fifth transistor M5 includes the source terminal that is coupled to the drain terminal of the first transistor M1, a drain terminal coupled to the organic light emitting diode OLED, and a gate terminal coupled to the emission control line E. The fifth transistor M5 is turned on when the emission control signal EMI is not being supplied, thereby supplying current from the first transistor M1 to the organic light emitting diode OLED.

The sixth transistor M6 includes a source terminal coupled to the storage capacitor Cst, and drain and gate terminals coupled to the (n-1)th scan line Sn-1. Further, the sixth transistor M6 is turned on when the scan signal SS is transmitted to the (n-1)th scan line Sn-1, thereby initializing the storage capacitor Cst and the gate terminal of the first transistor M1.

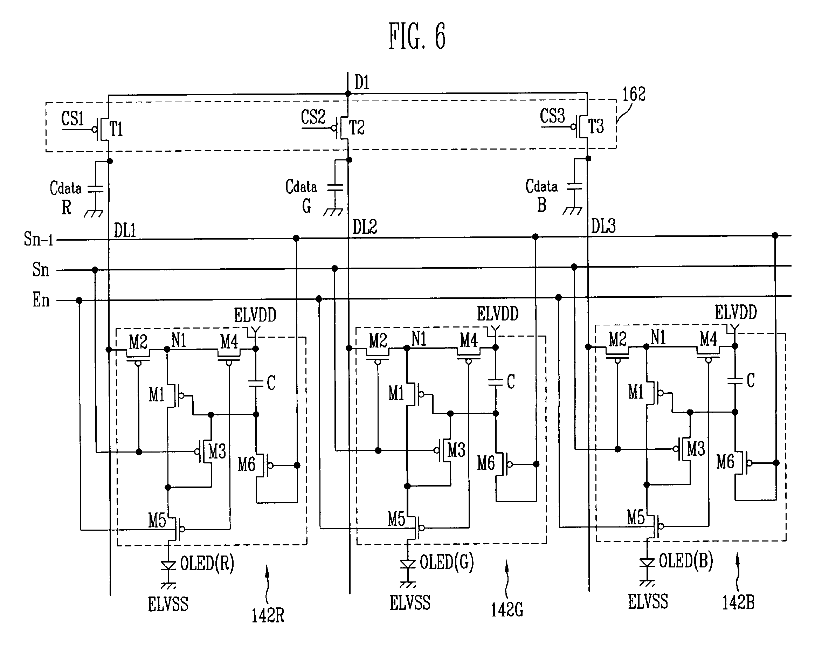

FIG. 6 is a circuit diagram illustrating the coupling of the demultiplexer 162 of FIG. 4 to the pixel circuit 142 of FIG. 5. In the exemplary embodiment shown, one demultiplexer 162 is coupled with three pixel circuit of red (R) 142R, green (G) 142G, and blue (B) 142B, so that i is 3.

The operations of the demultiplexer 162 and the pixel 140 are described with reference to FIGs. 3 and 6. First, the scan signal SS is transmitted to the (n-1)th scan line Sn-1 during the scan period of the one horizontal period 1H. When the scan signal SS is transmitted to the (n-1)th scan line Sn-1, each sixth transistor M6 of the pixels 142R, 142G and 142B is turned on. As the sixth transistor M6 is turned on, the storage capacitor Cst and the gate terminal of the first transistor M1 are coupled to the (n-1)th scan line Sn-1. That is, when the scan signal SS is transmitted to the (n-1)th scan line Sn-1, the scan signal SS is supplied to each storage capacitor Cst and each gate terminal of the first transistor M1 provided in the pixels 142R, 142G and 142B, thereby initializing each storage capacitor Cst and each gate terminal of the first transistor M1. The scan signal SS has a voltage level lower than the data signal R, G, B.

When the scan signal SS is transmitted to the (n-1)th scan line Sn-1, the second transistor M2 coupled to the nth scan line Sn remains turned off.

Then, the first, second, and third switching devices T1, T2, T3 are turned on in sequence by the first, second, and third control signals CS1, CS2, CS3 transmitted in sequence during the data period. When the first switching device T1 is turned on by the first control signal CS1, the data signal R, G, B is transmitted from the 1st first data line D1 to the 1st second data line DL1. The first data capacitor Cdata1 is charged with voltage corresponding to the data signal R, G, B transmitted to the 1st second data line DL1.

When the second switching device T2 is turned on by the second control signal CS2, the data signal R, G, B is transmitted from the 1st first data line D1 to the 2nd second data line DL2. The second data capacitor Cdata2 is charged with voltage corresponding to the data signal R, G, B transmitted to the 2nd second data line DL2. When the third switching device T3 is turned on by the third control signal CS3, the data signal R, G, B is transmitted from the 1st first data line D1 to the 3rd second data line DL3. The third data capacitor Cdata3 is charged with voltage corresponding to the data signal R, G, B transmitted to the 3rd second data line DL3. As seen in FIG. 3, the first, second, and third control signals CS1, CS2, CS3 are supplied during data periods of the one horizontal period 1H. However, the scan signal SS is not supplied during the data period, and, therefore, the data signal R, G, B is not being supplied to the pixels 142R, 142G and 142B while the control signals are being supplied.

Following the data period, the scan signal SS is transmitted to the nth scan line Sn. When the scan signal SS is transmitted to the nth scan line Sn, each second transistor M2 and each third transistor M3 of the pixels 142R, 142G and 142B are turned on. As each second transistor M2 and each third transistor M3 of the pixels 142R, 142G and 142B turn on, voltages corresponding to the data signals R, G, B stored in the first through third data capacitor Cdata1, Cdata2, Cdata3 are supplied to the respective first nodes N1 of the pixels 142R, 142G and 142B.

When the scan signal SS transmitted to the (n-1)th scan line Sn-1 is set to have a voltage level lower than that of the data signal R, G, B applied to the first node N1, the first transistor M1 is turned on. The voltage applied to the gate terminal of each first transistor M1 provided in the pixels 142R, 142G and 142B is initialized by this scan signal SS transmitted to the (n-1)th scan line Sn-1. As the first transistor M1 is turned on, the voltage corresponding to the data signal R, G, B applied to the first node N1 is supplied to one terminal of the storage capacitor Cst via the first transistor M1 and the third transistor M3. As a result, each storage capacitor Cst provided in the pixels 142R, 142G and 142B is charged with voltage corresponding to the data signal R, G, B. In addition to the voltage corresponding to the data signal R, G, B, the storage capacitors Cst are also charged with voltage corresponding to the threshold voltage of the first transistor M1. While the emission control signal EMI is not supplied through the emission control line En, the fourth and fifth transistors M4 and M5 are turned on and current corresponding to the voltage charged in the storage capacitor Cst is supplied to each organic light emitting diode OLED(R), OLED(G), OLED(B), causing them to emit light.

Thus, according to an embodiment of the present invention, the demultiplexer 162 is employed for splitting and supplying the data signal R, G, B from one of the first data lines D1 to i second data lines DL. The data capacitor Cdata1, Cdata2, Cdata3 is charged with the voltage corresponding to the data signal R, G, B during the data period, and supplies the charged voltage to the pixel 140 during the scan period. According to an embodiment of the present invention, the scan period for supplying the scan signal SS and the data period for supplying the data signal R, G, B do not overlap. As a result, the voltage applied to the gate terminal of the third transistor M3 does not fluctuate, allowing the organic light emitting display to stably display an image. Further, the voltages stored in the data capacitors Cdata1, Ddata2, Cdata3, corresponding to the data signals R, G, B, are supplied to the pixels 140 at the same time. As a result, the organic light emitting display can display an image with uniform brightness.

However, even with the same data signal R, G, B supplied, each organic light emitting display emits light with a different brightness due to material properties of the organic light emitting diodes OLED. When the same red, green, or blue data signal R, G, B is supplied to the organic light emitting display, emission efficiency varies from a high value for a green organic light emitting diode OLED(G), to lower values for a red organic light emitting diode OLED(R), and a blue organic light emitting diode OLED(B) as shown in Equation 1.

$$G_{efficiecy} > R_{efficiency} > B_{efficiency} \qquad \text{[Equation 1]}$$

G where $G_{efficiecy}$, $R_{efficiency}$, $B_{efficiency}$ denote the emission efficiencies of the organic light emitting diodes emitting green, red, and blue lights OLED(G), OLED(R), and OLED(B).

When the emission efficiency of the organic light emitting diodes OLED is different for lights of different colors, white balance is poor and it is impossible to represent a desired color. Therefore, in the organic light emitting display of the present invention, the capacitance of the data capacitor Cdata is determined taking into account the different efficiencies of emission for lights of different color. For example, the second data capacitor Cdata2 that stores the green data signal G is set to have the highest capacitance, and the third data capacitor Cdata3 that stores the blue data signal B is set to have the lowest capacitance. Then, a red pixel R, a green pixel G and a blue pixel B are properly adjusted to achieve white balance and better picture quality.

A voltage VG applied to the gate terminal of the first transistor M1 provided in each pixel is determined by Equation 2.

$$VG = (Cdata \times Vdata + Cst \times Vint) / (Cdata + Cst) \qquad \text{[Equation 2]}$$

where Vdata is a voltage corresponding to the data signal R, G, B stored in the data capacitor Cdata during a current frame, and Vint is a voltage corresponding to the data signal R, G, B stored in the storage capacitor Cst during a previous frame.

Referring to Equation 2, the voltage VG applied to the gate terminal of the first transistor M1 increases as the capacitance of the data capacitor Cdata increases. For example, in the case of Cst = 1 and Vint = 1, the following Equation 3 is obtained.

$$VG = (Cdata \times Vdata + 1) / (Cdata + 1) \qquad \text{[Equation 3]}$$

In Equation 3, when Vdata is 10 and Cdata is 10, VG is determined as about 9.18V. Further, when Vdata is 10 and Cdata is 1000, VG is determined as about 10V. Therefore, as the capacitance of the data capacitor Cdata increases the voltage VG applied to the gate terminal of the first transistor M1 also increases. When the voltage VG applied to the gate terminal of the first transistor M1 increases, the charge stored in the storage capacitor Cst also decreases. Decrease in the charge of the storage capacitor Cst reduces the current supplied by the storage capacitor Cst to the organic light emitting diode OLED. Thus, according to an embodiment of the present invention, the capacitance of the data capacitor Cdata is set with a high value for the second data capacitor Cdata2, corresponding to the green organic light emitting diode OLED(G), a lower value for the first data capacitor Cdata1, corresponding to the red organic light emitting diode OLED(R), and even a lower value for the third data capacitor Cdata3, corresponding to the blue organic light emitting diode OLED(B). This gradation of capacitance values compensates for the differences between the emission efficiencies of the different diodes and controls the white balance.

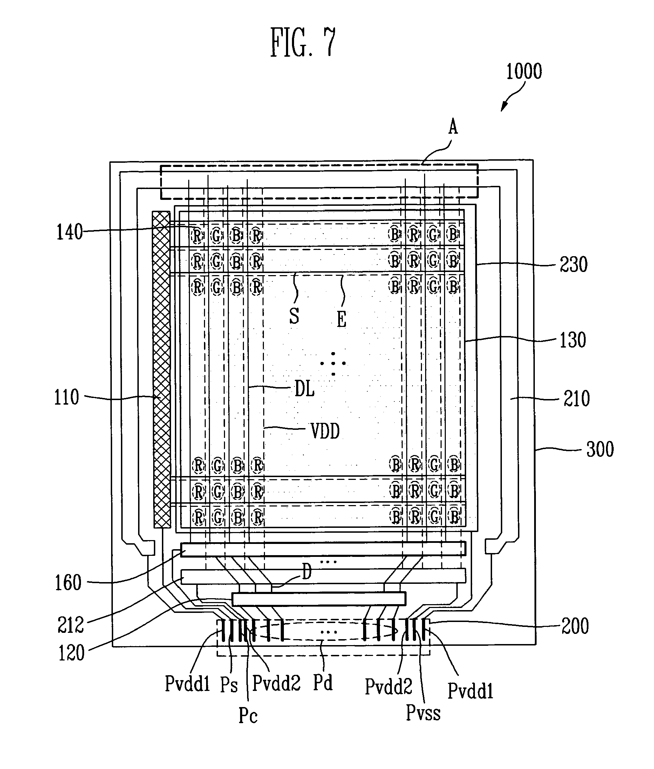

FIG. 7 illustrates a first layout 1000 of the organic light emitting display according to embodiments of the present invention. The organic light emitting display having the first layout 1000 includes a pixel portion 130 formed on a substrate 300 and including a plurality of pixels 140 defined by a plurality of second data lines DL, a plurality of scan lines S, and a plurality of pixel power source lines VDD. The first layout 1000 also includes a first power source line 210 and an auxiliary power source line 212 coupled to the pixel power source line VDD, a data driver 120, and a demultiplexer block 160.

According to an embodiment of the present invention, the first layout 1000 of the organic light emitting display further includes a scan driver 110, a second power source line 230, and a pad part 200.

The scan driver 110 is located on one side of the pixel portion 130 and is electrically coupled to a first pad Ps of the pad part 200. The scan driver 110 supplies the scan signals SS to the scan lines S1 through Sn in sequence during the scan period of the one horizontal period 1H in response to the scan control signal SCS supplied from the first pad Ps.

The data driver 120 is electrically coupled to second pads Pd of the pad part 200 and to the first data line D. The data driver 120 generates a data signal corresponding to the data control signal DCS and the external data Data supplied from the second pads Pd, and supplies the generated data signals to the first data lines D. The data driver 120 supplies i data signals to the respective first data lines D during the data period of the one horizontal period 1H. The data driver 120 can be directly formed on the substrate 300, or embedded as a chip on the substrate 300. For example, the data driver 120 can be embedded as a chip on the substrate 300 by a chip-on glass method, a wire bonding method, a flip-chip method, a beam lead method, or the like.

The first power source line 210 is formed adjacent to all sides of the pixel portion 130 along the edges of the substrate 300 except where the pad part 200 is located. The first power source line 210 includes opposite ends coupled to a third pad Pvdd1 of the pad part 200. Further, the first power source line 210 supplies voltage received through the third pad Pvdd1 to first ends of the pixel power source lines VDD.

The auxiliary power source line 212 is formed to be adjacent to a bottom side of the pixel portion 130. The auxiliary power source line 212 includes opposite ends electrically coupled to a fourth pad Pvdd2 of the pad part 200. The auxiliary power source line 212 supplies the voltage received through the fourth pad Pvdd2 to second ends of the pixel power source lines VDD.

The second power source line 230 is formed over the area of the pixel portion 130. The second power source line 230 commonly supplies the voltage of the second power source line ELVSS received through a fifth pad Pvss of the pad part 200 to each pixel 140.

The demultiplexer block 160 supplies i data signals received through the first data line D to i second data lines DL in response to the control signals CS1, CS2, CS3 transmitted from a sixth pad Pc of the pad part 200. Further, the data signals sequentially supplied from the demultiplexer block 160 are stored in the data capacitor Cdata equivalently formed on the second data lines DL, and then supplied to the pixels 140 at the same time.

The capacitance values of the data capacitors Cdata coupled to, or equivalently formed on, the second data line DL are set in consideration of the emission efficiency of the red organic light emitting diode OLED(R), the green organic light emitting diode OLED(G), and the blue organic light emitting diode OLED(B). As a result, the second data capacitor Cdata2, coupled to the green pixel G, has the highest capacitance, and the third data capacitor Cdata3, coupled to the blue pixel B, has the lowest capacitance. To accomplish the variation in capacitance values of the data capacitors Cdata, in one embodiment overlapping areas between the first power source line 210 and the second data line DL coupled to the red pixel R, between the first power source line 210 and the second data line DL coupled to the green pixel G, and between the first power source line 210 and the second data line DL coupled to the blue pixel B are set to be different from one another. The overlapping areas occur in portion "A" that is demarcated toward the top of the substrate 300.

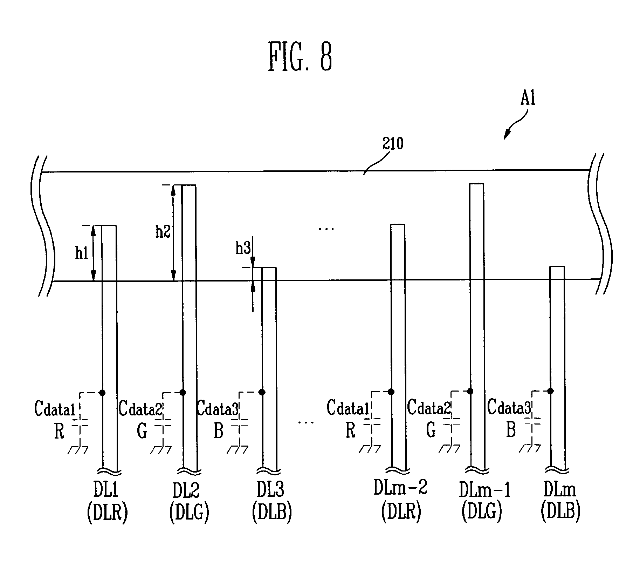

FIG. 8 is an enlarged view showing a first embodiment A1 of the portion "A" shown in FIG. 7. The second data lines DL are equivalently forming the data capacitors Cdata (parasitic capacitor). The first data capacitor Cdata1 supplies a voltage corresponding to the data signal R to the red pixel R, the second data capacitor Cdata2 supplies a voltage corresponding to the data signal G to the green pixel G, and the third data capacitor Cdata3 supplies a voltage corresponding to the data signal B to the blue pixel B. The capacitance values of these three data capacitors Cdata1, Cdata2, Cdata3 are set to be different from one another.

For example, the second data lines DL1 coupled to the red pixel R overlaps the first power source line 210 by a first length h1, so that the first data capacitor Cdata1 is set to have a predetermined capacitance corresponding to the first length h1. Similarly, the second data lines DL2 coupled to the green pixel G overlaps the first power source line 210 by a second length h2. The second length h2 is longer than the first length h1, so the second data capacitor Cdata2 will have a higher capacitance than the first data capacitor Cdata1. Also, the second data lines DL3 coupled to the blue pixel B overlaps the first power source line 210 by a third length h3. The third length h3 is shorter than the first length h1, so the capacitance of the third data capacitor Cdata3 is lower than the first capacitor Cdata1.

Thus, the capacitance of the data capacitors Cdata is set in decreasing order from the second capacitor Cdata2 to the first capacitor Cdata1 to the third capacitor Cdata3 (Cdata2 (G) > Cdata1 (R) > Cdata3 (B)). This helps improve the white balance.

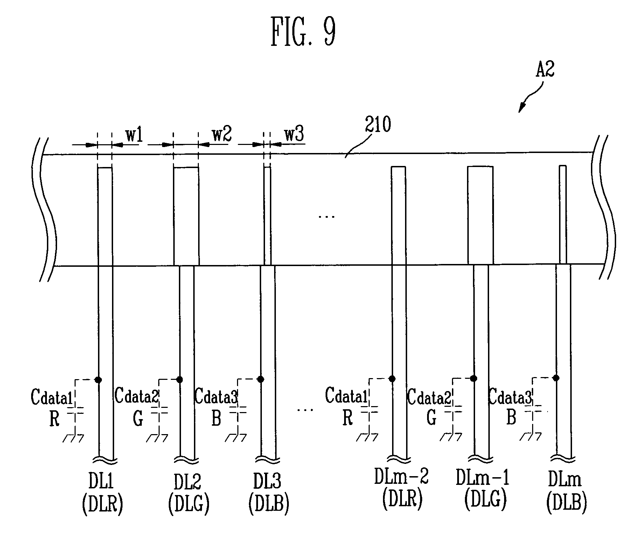

FIG. 9 is an enlarged view showing "A2" which is a second embodiment of the portion "A" shown in FIG. 7. The second data lines DL are equivalently forming the data capacitors Cdata. In other words, the data capacitors Cdata are parasitic capacitors forms by the second data lines DL. The first data capacitor Cdata1 supplies a voltage corresponding to the data signal R to the red pixel R, the second data capacitor Cdata2 supplies a voltage corresponding to the data signal G to the green pixel G, and the third data capacitor Cdata3 supplies a voltage corresponding to the data signal B to the blue pixel B. The three data capacitors Cdata1, Cdata2, Cdata3 are set to have capacitances that are different from one another.

For example, the second data lines DL1 coupled to the red pixel R, overlaps the first power source line 210 by a first width W1, so that the first data capacitor Cdata1 is set to have a predetermined capacitance corresponding to the first width W1. Similarly, the second data lines DL2 coupled to the green pixel G, overlaps the first power source line 210 by a second width W2. The second width W2 is wider than the first width W1, so that the second data capacitor Cdata2 is set to have a capacitance higher than the first capacitor Cdata1. Also, the second data lines DL3 coupled to the blue pixel B overlaps the first power source line 210 by a third width W3. The third width W3 is smaller than the first width W1, so that the third data capacitor Cdata3 is set to have a capacitance lower than the first capacitor Cdata1.

Thus, the capacitance of the data capacitors Cdata is set in the decreasing order from the second capacitor Cdata2 to the first capacitor Cdata1 and to the third capacitor Cdata3 (Cdata2 (G) > Cdata1 (R) > Cdata3 (B)), thereby preserving the white balance regardless of the emission efficiency of the red, green and blue organic light emitting diodes OLED.

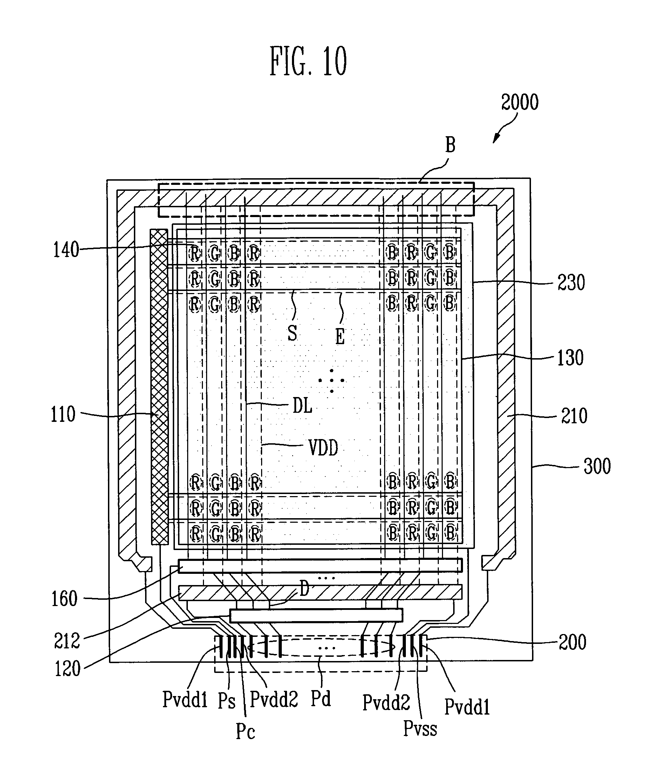

FIG. 10 illustrates a second layout 2000 of the organic light emitting display of the present invention. The second layout 2000 has the same configuration as the first layout 1000 except for portion "B".

In the second layout 2000 of the organic light emitting display of the present invention, the data capacitors Cdata coupled to, or equivalently formed on, the second data lines DL are set differently according to overlapping areas between the second data line DL and the first power source line 210. The overlapping areas between the second data lines DL and the first power source lines 210 are varied taking into account voltage drop due to line resistance depending on the length of the first power source line 210. Thus, the data capacitors Cdata have different capacitance values according to the voltage drop in the first power source line, thereby allowing the organic light emitting display to display an image with uniform brightness.

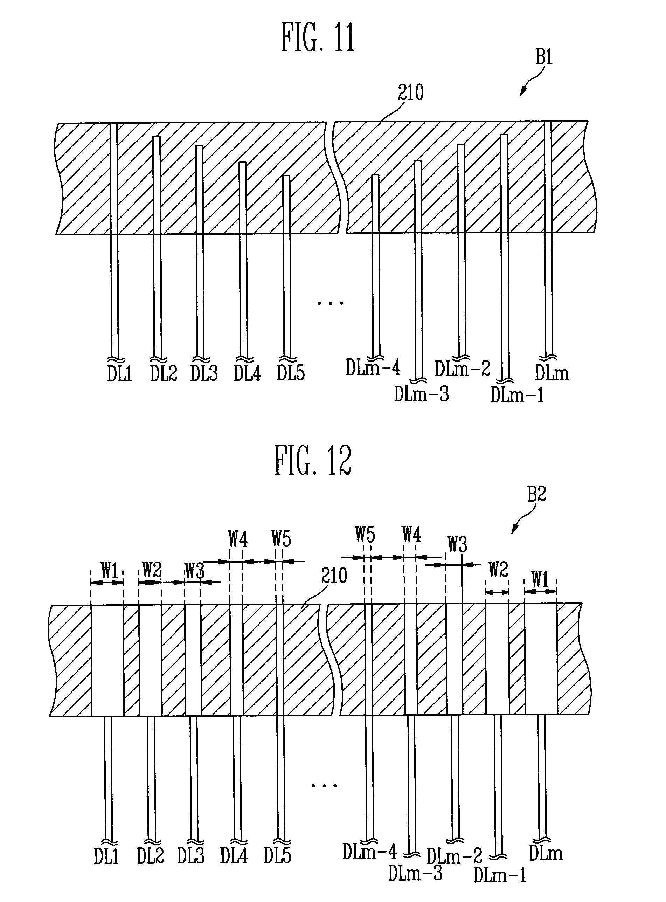

FIG. 11 is an enlarged view showing a first embodiment "B1" of the portion "B" shown in FIG. 10. The second data lines DL are formed having the same line width, but different overlapping lengths with the first power source line 210 that result in different overlapping areas. Therefore, the consecutive second data lines DL have lengths that vary according to the location on the first power source line 210 where the second data line DL couples to the first power source line 210. The second power source lines DL becomes shorter as it goes from an edge portion of the first power source line 210 to a center portion. Thus, the overlapping areas between the first power source line 210 and the second data lines DL become smaller as the second data line DL goes from the 1st second data line DL1 to the $(m/2)^{th}$ second data line DLm/2. Likewise, the overlapping areas between the first power source line 210 and the second data lines DL become larger as the second data line DL goes from the $(m/2+1)^{th}$ second data line DLm/2+1 to the $m^{th}$ second data line DLm. The gradual decrease in the overlapping areas and the subsequent gradual increase are symmetric such that the overlapping area between the $k^{th}$ second data line DLk and the first data line 210 is equal to that between $(m+1-k)^{th}$ second data line DLm+1-k and the first data line 210, where k is a positive integer less than m/2.

As explained above, the capacitance of the data capacitor Cdata become smaller going from the edge of the first power source line 210 to its center. This change in the capacitance values compensates for the voltage drop in the first power source line 210 from edges to center and allows the image to be displayed with uniform brightness.

FIG. 12 is an enlarged view showing a second embodiment "B2" of the portion "B" shown in FIG. 10. The second data lines DL shown in this figure also have different overlapping area with the first power source line 210. In this embodiment, the width of the overlapping areas of the consecutive second data lines DL with the first power source line 210 varies from the edges of the first power source line 210 to its center. The second data lines DL become successively narrower from an edge portion of the first power source line 210 toward its center portion.

Due to this successive narrowing of the overlapping areas, the 1st second data line DL1 overlaps the first power source line 210 by a first width W1, and the 2nd second data line DL2 overlaps the first power source line 210 by a second width W2 narrower than the first width W1. Similarly, the $m^{th}$ second data line DLm overlaps the first power source line 210 by the first width W1, and the $(m-1)^{th}$ second data line DLm-1 overlaps the first power source line 210 by the second width W2. Thus, the line width of the second power source line DL becomes narrower as it goes from the edge portions of the first power source line 210 to the center portion. Consequently, the capacitance of the data capacitors Cdata decrease going from the edges of the first power source line 210 to its center. Therefore, the voltage drop from the edges to the center of the first power source line 210 is compensated by the varying capacitances of the data capacitors Cdata and an image with the uniform brightness may be displayed.

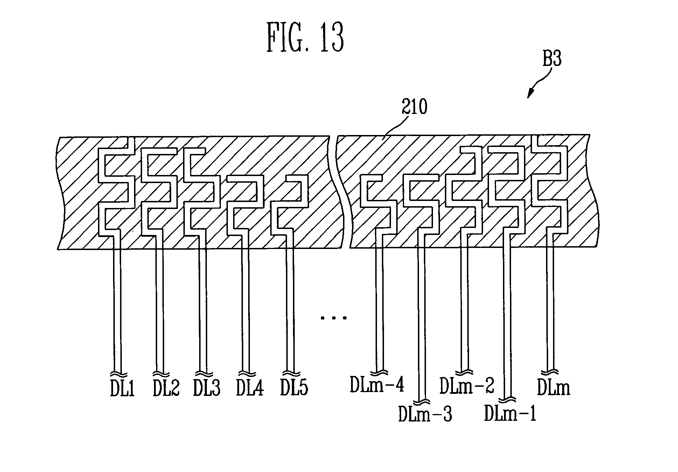

FIG. 13 is an enlarged view showing a third embodiment "B3" of the portion "B" shown in FIG. 10. In this embodiment too, the second data lines DL have different capacitances that result from their different overlapping areas with the first power source line 210. As the figure shows, the second data lines DL are bent in S-shapes to have different lengths and therefore different overlapping areas with the first power source line 210.

The S-shaped curves of the second power source lines DL become shorter in consecutive lines from an edge portion of the first power source line 210 to a center portion. Thus, the overlapping areas between the first power source line 210 and the second data lines DL become smaller as the second data lines DL go from the 1st second data line DL1 to the $(m/2)^{th}$ second data line DLm/2. Similarly, the overlapping areas between the first power source line 210 and the second data lines DL become larger as the second data lines DL go from the $(m/2+1)^{th}$ second data line DLm/2+1 to the $m^{th}$ second data line DLm. The symmetrical decrease and subsequent increase in the overlapping areas of the consecutive second data lines DL causes the overlapping area between the $k^{th}$ second data line DLk and the first data line 210 to be equal to that between $(m+1-k)^{th}$ second data line DLm+1-k and the first data line 210, where k is a positive integer less than m/2.

Thus, the capacitance values of the data capacitors Cdata become smaller going from the edges to the center of the first power source line 210, so that the voltage drop in the first power source line 210 is compensated for and an image may be displayed with uniform brightness.

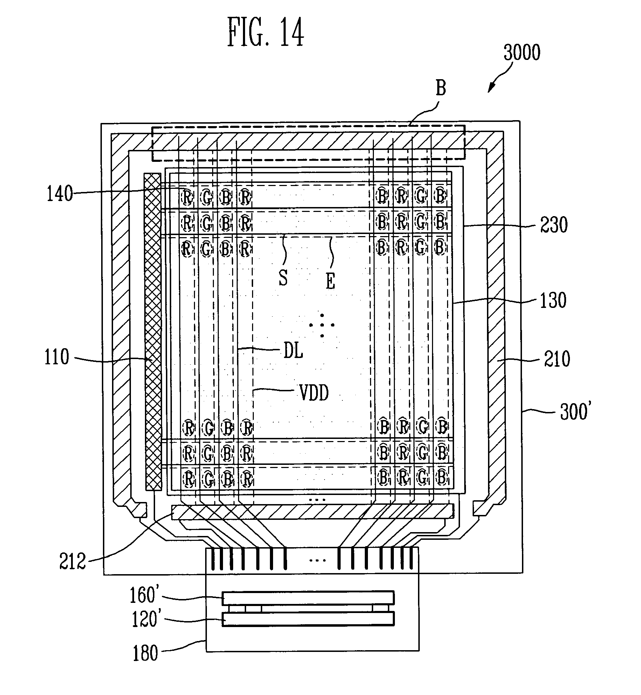

FIG. 14 illustrates a third layout 3000 of the organic light emitting display of the present invention. In FIG. 14, the organic light emitting display has the same configuration as that illustrated for the second layout in FIG. 10 except for the location of the data driver 120 and the demultiplexer block 160 that are different.

The third layout 3000 includes a data driver 120' and a demultiplexer block 160' that are embedded on a flexible printed circuit 180 coupled to a substrate 300'. Thus, the data driver 120' and the demultiplexer block 160' are electrically coupled to a second data line DL through a pad part of the substrate 300, thereby supplying a data signal. Alternatively, the data driver 120' and the demultiplexer block 160' may be mounted on a chip on board mounted on a printed circuit board, a chip on film directly mounted on the film, a general film type connector used in a tape carrier package, or the like.

As described above, the present invention provides an organic light emitting display, in which a data signal received through one output line is split and supplied to a plurality of second data lines, thereby decreasing the number of output lines required and reducing production cost. In an embodiment, voltages corresponding to the data signals are sequentially charged in data capacitors, while the charged voltages are supplied to the pixels all at the same time. Because the voltages charged in the data capacitors are supplied to the pixels simultaneously, the organic light emitting display is allowed to display an image with uniform brightness. In an embodiment, scan periods for supplying the scan signals do not overlap with data periods for supplying the data signals. This feature yields a stable image. In an embodiment, the capacitance of a data capacitor is set depending on the emission efficiency of its corresponding organic light emitting diode, thereby keeping a proper white balance. In an embodiment, the capacitance of the data capacitor is set to compensate the voltage drop in the first power source line, thereby displaying an image with uniform brightness.

**Claims**

1. An organic light emitting display comprising:

   a scan driver (110) to supply scan signals to a plurality of scan lines (S1...Sn);
   a data driver (120) to supply data signals to a plurality of output lines (D1...Dm/i);
   a demultiplexer (162) provided on each output line (D1...Dm/i) to supply the data signals to a plurality of data lines (DL1...DLm);
   a first power source line (210) to supply first power through a first side of a plurality of pixel power source lines (VDD);
   a pixel portion (130) comprising a plurality of first pixels (G) coupled to one of the plurality of scan lines (S1...Sn), a first data line (DL2) of the plurality of data lines (DL1...DLm), and one of the plurality of pixel power source lines (VDD), each first pixel (G) comprising a corresponding first one of a plurality of first capacitors (Cst) adapted to receive a data signal from the first data line (DL2) and a corresponding one of a plurality of first organic light emitting diodes (OLED) having a first emission efficiency and each first pixel (G) being adapted to emit light corresponding to a data signal capacitively stored in the corresponding one of the first capacitors (Cst);
   the pixel portion (130) further comprising a plurality of second pixels (R) coupled to one of the plurality of scan lines (S1...Sn), a second data line of the plurality of data lines (DL1), and another one of the plurality of pixel power source lines (VDD), each second pixel (R) comprising a corresponding second one of the plurality of first capacitors (Cst) adapted to receive a data signal from the second data line (DL1) and a corresponding one of a plurality of second organic light emitting diodes (OLED) having a second emission efficiency lower than the first emission efficiency and each second pixel (R) being adapted to emit light corresponding to a data signal capacitively stored in the corresponding second one of the first capacitors (Cst);

   **characterised in that**
   the pixel portion (130) further comprises a plurality of second capacitors (Cdata1, Cdata2, Cdata3) formed to have different capacitances corresponding to overlapping areas between the first power source line (210) and the respective data lines (DL2, DL1), each second capacitor (Cdata1, Cdata2, Cdata3) being capable of storing voltage corresponding to a data signal and supplying the stored voltage to the pixels (G, R), wherein a first one of the plurality of second capacitors (Cdata1, Cdata2, Cdata3) connected to the first data line (DL2) has a first capacitance and a second one of the plurality of second capacitors (Cdata1, Cdata2, Cdata3) connected to the second data line (DL1) has a second capacitance smaller than the first capacitance.

2. The organic light emitting display of claim 1, further comprising a plurality of third pixels (B) coupled to one of the plurality of scan lines, a third data line (DL3) of the plurality of data lines (DL1...DLm), and another one of the plurality of pixel power source lines (VDD), each third pixel (B) comprising a corresponding third one of the plurality of first capacitors (Cst) adapted to receive a data signal from the third data line (DL3) and a corresponding one of a plurality of third organic light emitting diodes (OLED) having a third emission efficiency lower than the second emission efficiency and each third pixel (B) being adapted to emit light corresponding to a data signal capacitively stored in the corresponding third one of the first capacitors (Cst), and

a third one of the plurality of second capacitors (Cdata1, Cdata2, Cdata3) connected to the third data line (DL3) and having a third capacitance smaller than the second capacitance,

wherein the each first organic light emitting diode (OLED) is a green organic light emitting diode each second organic light emitting diode (OLED) is a red organic light emitting diode, and each third organic light emitting diode (OLED) is a blue organic light emitting diode.

3.    The organic light emitting display according to claim 2, wherein the first one of the plurality of second capacitors (Cdata2) is formed by a first overlapping area larger than a second overlapping area forming the second one of the plurality of second capacitors (Cdata1), and wherein a third overlapping area forming the third one of the plurality of second capacitors (Cdata3) is smaller than the second overlapping area.

4.    The organic light emitting display according to claim 3, wherein the first data line (DL2) coupled to the first plurality of pixels (G) overlaps the power source line (210) by a first width (w2), and the second data line (DL1) coupled to the second plurality of pixels (R) overlaps the power source line (210) by a second width (w1) narrower than the first width (w2).

5.    The organic light emitting display according to one of the claims 3 or 4, wherein the first data line (DL2) coupled to the first plurality of pixels (G) overlaps the power source line by a first length (h2), and the second data line (DL1) coupled to the plurality of second pixels (R) overlaps the power source line (210) by a second length (h1) shorter than the first length (h2).

6.    The organic light emitting display according to claim 5, wherein the third data line (DL3) coupled to the third plurality of pixels (B) overlaps the power source line (210) by a third length (h3) shorter than the second length (h1).

7.    The organic light emitting display according to claim 4 or to claims 4 and 5, wherein the third data line (DL3) coupled to the third plurality of pixels (B) overlaps the power source line (210) by a third width (w3) narrower than the second width (w1).

8.    The organic light emitting display according to claim 1, wherein the scan driver (110) is adapted to supply the scan signal (SS) during a first period (SCAN PERIOD) of one horizontal period (1H), and the data driver (120) is adapted to supply the data signals (R, G, B) to the output lines (D1...Dm/i) during a second period (DATA PERIOD) of the one horizontal period (1H) excluding the first period (SCAN PERIOD).

9.    The organic light emitting display according to claim 1, wherein each demultiplexer (162) comprises a plurality of transistors (T1, T2, T3), each transistor (T1, T2, T3) being coupled to one of the plurality of data lines (D1...Dm/i).

10.   The organic light emitting display according to claim 9, wherein the plurality of transistors (T1, T2, T3) are turned on in sequence, and the first one of the plurality of second capacitors (Cdata2), the second one of the plurality of second capacitors (Cdata1), and the third one of the plurality of second capacitors (Cdata3) are charged with voltages corresponding to the data signals (R, G, B) when the transistors (T1, T2, T3) are turned on.

11.   The organic light emitting display according to claim 10, wherein the voltages stored in the first one of the plurality of second capacitors (Cdata2), the second one of the plurality of second capacitors (Cdata1), and the third one of the plurality of second capacitors (Cdata3) are supplied to the plurality of first pixels (G), the plurality of second pixels (R) and the plurality of third pixels (B) for the first period (SCAN PERIOD).

12.   The organic light emitting display according to any one of the preceding claims, further comprising:

a substrate (300);
a pad part (200) formed on the substrate (300), the pad part (200) having first pads (Ps), second pads (Pd), third pads (Pvdd1), fourth pads (Pvdd2), fifth pads (Pvss), and sixth pads (Pc);

wherein the scan driver (110) is located on one side of the pixel portion (130) and electrically coupled to the first pads (Ps) and to the scan lines (S1...Sn); and the data driver (120) is directly formed on the substrate (300) or embedded as a chip on the substrate (300) and is electrically coupled to an auxiliary power source line (212), to the second pads (Pd), and to the first data line (DL2);

the first power source line (210) is located adjacent to all sides of the pixel portion (130) along edges of the substrate (300) except where the pad part (200) is located and coupled to the third pads (Pvdd1) and to the pixel power source lines (VDD);

the auxiliary power source line (212) is located on the substrate (300) along an edge where the pad part (200) is located and coupled to the fourth pads (Pvdd2) and to the plurality of pixel power source lines (VDD);

a second power source line (230) is formed on the substrate (300) coupled to the fifth pads (Pvss) and to each of the pixels (R, G, B); and

a demultiplexer block (160) is coupled to the first data line (DL2), the second data line (DL1), and to the sixth pads (Pc).

**13.** The organic light emitting display of claim 12, wherein the data driver (120) and the demultiplexer block (160) are embedded on a flexible printed circuit coupled to the substrate (300) and wherein the data driver (120) and the demultiplexer block (160) are electrically coupled to the second data line (DL1) through the pad part (200) of the substrate (300).


**Patentansprüche**

**1.** Organische lichtemittierende Anzeigevorrichtung, aufweisend:

einen Ansteuertreiber (110), der eine Vielzahl von Ansteuerleitungen (S1... Sn) mit Ansteuersignalen versorgt;
einen Datentreiber (120), der eine Vielzahl von Ausgangsleitungen (D1...Dm/i) mit Datensignalen versorgt;
einen auf jeder Ausgangsleitung (D1...Dm/i) bereitgestellten Demultiplexer (162), der eine Vielzahl von Datenleitungen (DL1...DLm) mit den Datensignalen versorgt;
eine erste Spannungsquellenleitung (210) zur Versorgung mit einer ersten Spannung über eine erste Seite einer Vielzahl von Pixelspannungsquellenleitungen (VDD);
einen Pixelbereich (130), der eine Vielzahl erster Pixel (G), die mit einer Ansteuerleitung aus der Vielzahl von Ansteuerleitungen (S1...Sn), mit einer ersten Datenleitung (DL2) aus der Vielzahl von Datenleitungen (DL1 ...DLm) sowie mit einer Pixelspannungsquellenleitung aus der Vielzahl von Pixelspannungsquellenleitungen (VDD) gekoppelt sind, aufweist, wobei jeder erste Pixel (G) einen entsprechenden ersten Kondensator aus einer Vielzahl erster Kondensatoren (Cst), der ausgebildet ist, ein Datensignal von der ersten Datenleitung (DL2) zu erhalten, und eine entsprechende organische Leuchtdiode aus einer Vielzahl erster organischer Leuchtdioden (OLED), welche eine erste Emissionseffizienz aufweist, aufweist, und wobei jeder erste Pixel (G) ausgebildet ist, Licht entsprechend einem Datensignal, das im entsprechenden Kondensator der ersten Kondensatoren (Cst) kapazitiv gespeichert wird, zu emittieren;

wobei der Pixelbereich (130) weiterhin eine Vielzahl zweiter Pixel (R), die mit einer Ansteuerleitung aus der Vielzahl von Ansteuerleitungen (S1...Sn), mit einer zweiten Datenleitung aus der Vielzahl von Datenleitungen (DL1) sowie mit einer weiteren Pixelsparnzungsquellenleitung aus der Vielzahl von Pixelspannungsquellenleitungen (VDD) gekoppelt sind, aufweist, wobei jeder zweite Pixel (R) einen entsprechenden zweiten Kondensator aus der Vielzahl erster Kondensatoren (Cst), der ausgebildet ist, ein Datensignal von der zweiten Datenleitung (DL1) zu erhalten, und eine entsprechende organische Leuchtdiode aus einer Vielzahl zweiter organischer Leuchtdioden (OLED), welche eine zweite Emissionseffizienz aufweist, die niedriger als die erste Emissionseffizienz ist, aufweist, und wobei jeder zweite Pixel (R) ausgebildet ist, Licht entsprechend einem Datensignal, das im entsprechenden zweiten Kondensator der ersten Kondensatoren (Cst) kapazitiv gespeichert wird, zu emittieren;
**dadurch gekennzeichnet, dass**
der Pixelbereich (130) weiterhin eine Vielzahl zweiter Kondensatoren (Cdata1, Cdata2, Cdata3) aufweist, die derart ausgebildet sind, dass sie unterschiedliche Kapazitäten, die überlappenden Flächen zwischen der ersten Spannungsquellenleitung (210) und den jeweiligen Datenleitungen (DL2, DL1) entsprechen, aufweisen, wobei jeder zweite Kondensator (Cdata1, Cdata2, Cdata3) befähigt ist, Spannung entsprechend einem Datensignal zu speichern und die Pixel (G, R) mit der gespeicherten Spannung zu versorgen, und wobei ein mit der ersten Datenleitung (DL2) verbundener erster Kondensator aus der Vielzahl zweiter Kondensatoren (Cdata1, Cdata2, Cdata3) eine erste Kapazität aufweist und ein mit der zweiten Datenleitung (DL1) verbundener zweiter Kondensator aus der Vielzahl zweiter Kondensatoren (Cdata1, Cdata2, Cdata3) eine zweite Kapazität aufweist, die geringer als die erste Kapazität ist.

**2.** Organische lichtemittierende Anzeigevorrichtung nach Anspruch 1, weiterhin aufweisend eine Vielzahl dritter Pixel (B), die mit einer Ansteuerleitung aus der Vielzahl von Ansteuerleitungen, mit einer dritten Datenleitung (DL3) aus der Vielzahl von Datenleitungen (DL1...DLm) und mit einer weiteren Pixelspannungsquellenleitung aus der Vielzahl von Pixelspannungsquellenleitungen (VDD) gekoppelt sind, wobei jeder dritte Pixel (B) einen entsprechenden dritten Kondensator aus der Vielzahl erster Kondensatoren (Cst), der ausgebildet ist, ein Datensignal von der dritten Datenleitung (DL3) zu erhalten, und eine entsprechende organische Leuchtdiode aus einer Vielzahl dritter organischer Leuchtdioden (OLED), welche eine dritte Emissionseffizienz aufweist, die niedriger als die zweite Emissionseffizienz ist, aufweist, und wobei jeder dritte Pixel (B) ausgebildet ist, Licht entsprechend einem Datensignal, das im entsprechenden dritten Kondensator der ersten Kondensatoren (Cst) kapazitiv gespeichert ist, zu emittieren;

einen dritten Kondensator aus der Vielzahl zweiter Kondensatoren (Cdata1, Cdata2, Cdata3), der mit der dritten Datenleitung (DL3) verbunden ist und eine dritte Kapazität aufweist, die geringer als die zweite Kapazität ist,

wobei jede erste organische Leuchtdiode (OLED) eine grüne organische Leuchtdiode, jede zweite organische Leuchtdiode (OLED) eine rote organische Leuchtdiode und jede dritte organische Leuchtdiode (OLED) eine blaue organische Leuchtdiode ist.

3. Organische lichtemittierende Anzeigevorrichtung nach Anspruch 2, wobei der erste Kondensator aus der Vielzahl zweiter Kondensatoren (Cdata2) durch eine erste überlappende Fläche ausgebildet ist, welche größer als eine zweite überlappende Fläche ist, die den zweiten Kondensator aus der Vielzahl zweiter Kondensatoren (Cdata1) ausbildet, und wobei eine dritte überlappende Fläche, die den dritten Kondensator aus der Vielzahl zweiter Kondensatoren (Cdata3) ausbildet, kleiner als die zweite überlappende Fläche ist.

4. Organische lichtemittierende Anzeigevorrichtung nach Anspruch 3, wobei die mit der ersten Vielzahl von Pixeln (G) gekoppelte erste Datenleitung (DL2) die Spannungsquellenleitung (210) um eine erste Breite (w2) überlappt, und wobei die mit der zweiten Vielzahl von Pixeln (R) gekoppelte zweite Datenleitung (DL1) die Spannungsquellenleitung (210) um eine zweite Breite (w1), die kleiner als die erste Breite (w2) ist, überlappt.

5. Organische lichtemittierende Anzeigevorrichtung nach einem der Ansprüche 3 oder 4, wobei die mit der ersten Vielzahl von Pixeln (G) gekoppelte erste Datenleitung (DL2) die Spannungsquellenleitung um eine erste Länge (h2) überlappt, und wobei die mit der Vielzahl zweiter Pixel (R) gekoppelte zweite Datenleitung (DL1) die Spannungsquellenleitung (210) um eine zweite Länge (h1) überlappt, die kleiner als die erste Länge (h2) ist.

6. Organische lichtemittierende Anzeigevorrichtung nach Anspruch 5, wobei die mit der dritten Vielzahl von Pixeln (B) gekoppelte dritte Datenleitung (DL3) die Spannungsquellenleitung (210) um eine dritte Länge (h3) überlappt, die kleiner als die zweite Länge (h1) ist.

7. Organische lichtemittierende Anzeigevorrichtung nach Anspruch 4 oder nach den Ansprüchen 4 und 5, wobei die mit der dritten Vielzahl von Pixeln (B) gekoppelte dritte Datenleitung (DL3) die Spannungsquellenleitung (210) um eine dritte Breite (w3) überlappt, die kleiner als die zweit Breite (w1) ist.

8. Organische lichtemittierende Anzeigevorrichtung nach Anspruch 1, wobei der Ansteuertreiber (110) zum Anlegen des Ansteuersignals (SS) während eines ersten Intervalls (SCAN PERIOD) eines horizontalen Intervalls (1H) ausgebildet ist, und wobei der Datentreiber (120) zum Anlegen der Datensignale (R, G, B) an die Ausgangsleitungen (D1...Dm/i) während eines zweiten Intervalls (DATA PERIOD) des einen horizontalen Intervalls (1H), von dem das erste Intervall (SCAN PERIOD) ausgenommen ist, ausgebildet ist.

9. Organische lichtemittierende Anzeigevorrichtung nach Anspruch 1, wobei jeder Demultiplexer (162) eine Vielzahl von Transistoren (T1, T2, T3) aufweist, und wobei jeder Transistor (T1, T2, T3) mit einer Datenleitung aus der Vielzahl von Datenleitungen (D1...Dm/i) gekoppelt ist.

10. Organische lichtemittierende Anzeigevorrichtung nach Anspruch 9, wobei die Vielzahl von Transistoren (T1, T2, T3) nacheinander eingeschaltet werden, und wobei der erste Kondensator aus der Vielzahl zweiter Kondensatoren (Cdata2), der zweite Kondensator aus der Vielzahl zweiter Kondensatoren (Cdata1) und der dritte Kondensator aus der Vielzahl zweiter Kondensatoren (Cdata3) mit Spannungen entsprechend den Datensignalen (R, G, B) geladen werden, wenn die Transistoren (T1, T2, T3) eingeschaltet werden.

11. Organische lichtemittierende Anzeigevorrichtung 10, wobei die Vielzahl erster Pixel (G), die Vielzahl zweiter Pixel (R) und die Vielzahl dritter Pixel (B) während des ersten Intervalls (SCAN PERIOD) mit den im ersten Kondensator aus der Vielzahl zweiter Kondensatoren (Cdata2), im zweiten Kondensator aus der Vielzahl zweiter Kondensatoren (Cdata1) und im dritten Kondensator aus der Vielzahl zweiter Kondensatoren (Cdata3) gespeicherten Spannungen versorgt werden.

12. Organische lichtemittierende Anzeigevorrichtung nach einem der vorhergehenden Ansprüche, weiterhin aufweisend:

ein Substrat (300);
einen Kontaktpadteil (200), der auf dem Substrat (300) ausgebildet ist, wobei der Kontaktpadteil (200) erste Kontaktpads (Ps), zweite Kontatpads (Pd), dritte Kontaktpads (Pvdd1), vierte Kontakpads (pvdd2), fünfte Kontaktpads (Pvss) und sechste Kontaktpads (Pc) aufweist;

wobei der Ansteuertreiber (110) auf einer Seite des Pixelbereichs (130) angeordnet ist und mit den ersten Kontakptads (Ps) und den Ansteuerleitungen (S1...Sn) elektrisch gekoppelt ist; und wobei der Datentreiber (120) direkt auf dem Substrat (300) ausgebildet oder als Chip auf dem Substrat (300) angeordnet ist und mit einer zusätzlichen Spannungsquellenleitung (212), den zweiten Kontaktpads (Pd) und der ersten Datenleitung (DL2) elektrisch gekoppelt ist;
und wobei die erste Spannungsquellenleitung (210), abgesehen von den Stellen, an denen der Kontaktpadteil (200) angeordnet ist, benachbart zu allen Seiten des Pixelbereichs (130) entlang Rändern des Substrats (300), angeordnet ist und mit den dritten Kontaktpads (Pvdd1) und den Pixelspannungsquellenleitungen (VDD) gekoppelt ist;
und wobei die zusätzliche Spannungsquellenleitung (212) auf dem Substrat (300) entlang einem Rand, an dem der Kontaktpadteil (200) angeordnet ist, angeordnet ist und mit den vierten Kontaktpads (Pvdd2) und der Vielzahl von Pixelspannungsquellenleitungen (VDD) gekoppelt ist;
und wobei eine zweite Spannungsquellenleitung (230) auf dem Substrat ausgebildet und mit den fünften Kontaktpads (Pvss) und jedem der Pixel (R, G, B) gekoppelt ist; und
wobei ein Demultiplexerblock (160) mit der ersten Datenleitung (DL2), der zweiten Datenleitung (DL1) und den sechsten Kontaktpads (Pc) gekoppelt ist.

13. Organische lichtemittierende Anzeigevorrichtung nach Anspruch 12, wobei der Datentreiber (120) und der Demultiplexerblock (160) auf einer mit dem Substrat (300) gekoppelten flexiblen Leiterplatte angeordnet sind, und wobei der Datentreiber (120) und der Demultiplexerblock (160) über den Kontaktpadteil (200) des Substrats (300) mit der zweiten Datenleitung (DL1) elektrisch gekoppelt sind.

## Revendications

1. Dispositif organique d'affichage à émission de lumière comportant :

une unité d'attaque de balayage (110) destinée à fournir des signaux de balayage à de multiples lignes de balayage (S1...Sn) ;
une unité d'attaque de données (120) destinée à fournir des signaux de données à de multiples lignes de sortie (D1...Dm/i) ;
un démultiplexeur (162) situé sur chacune des sorties (D1...Dm/i) pour fournir les signaux de données à de multiples lignes de données (DL1...DLm) ;
une première ligne (210) de source d'énergie destinée à fournir une première énergie à travers un premier côté de multiples lignes (VDD) de source d'énergie de pixels ;
une partie de pixels (130) comportant de multiples premiers pixels (G) reliés à l'une des multiples lignes de balayage (S1...Sn), à une première ligne de données (DL2) des multiples lignes de données (DL1...DLm), et à l'une des multiples lignes (VDD) de source d'énergie de pixels, chaque premier pixel (G) comportant un premier, correspondant, de multiples premiers condensateurs (Cst) conçus pour recevoir un signal de données provenant de la première ligne de données (DL2) et une, correspondante, de multiples premières diodes organiques d'émission de lumière (OLED) ayant un premier rendement d'émission, et chaque premier pixel (G) étant conçu pour émettre de la lumière correspondant à un signal de données stocké de façon capacitive dans celui, correspondant, des premiers condensateurs (Cst) ;
la partie de pixels (130) comportant en outre de multiples deuxièmes pixels (R) reliés à l'une des multiples lignes de balayage (S1...Sn), à une deuxième ligne de données des multiples lignes de données (DL1) et à une autre des multiples lignes (VDD) de source d'énergie de pixels, chaque deuxième pixel (R) comportant un second, correspondant, des multiples premiers condensateurs (Cst) conçus pour recevoir un signal de données provenant de la deuxième ligne de données (DL1) et l'une, correspondante, de multiples deuxièmes diodes organiques d'émission de lumière (OLED) ayant un deuxième rendement d'émission inférieur au premier rendement d'émission et chaque deuxième pixel (R) étant conçu pour émettre une lumière correspondant à un signal de données stocké de façon capacitive dans le second, correspondant, des premiers condensateurs (Cst) ;

**caractérisé en ce que**

la partie de pixels (130) comporte en outre de multiples seconds condensateurs (Cdata1, Cdata2, Cdata3) formés de façon à avoir des capacités différentes correspondant à des zones de chevauchement entre la première ligne de source d'énergie (210) et les lignes de données respectives (DL2, DL1), chaque second condensateur (Cdata1, Cdata2, Cdata3) étant capable de stocker une tension correspondant à un signal de données et de fournir la tension stockée aux pixels (G, R), un premier des multiples seconds condensateurs (Cdata1, Cdata2, Cdata3), connecté à la première ligne de données (DL2), ayant une première capacité et un second des multiples seconds condensateurs (Cdata1, Cdata2, Cdata3), connecté à la deuxième ligne de données (DL1), ayant une deuxième capacité inférieure à la première capacité.

2. Dispositif organique d'affichage à émission de lumière selon la revendication 1, comportant en outre de multiples troisièmes pixels (B) reliés à l'une des multiples lignes de balayage, à une troisième ligne de données (DL3) des multiples lignes de données (DL1...DLm), et à une autre des multiples lignes (VDD) de source d'énergie de pixels, chaque troisième pixel (B) comportant un troisième, correspondant, des multiples premiers condensateurs (Cst), conçu pour recevoir un signal de données provenant de la troisième ligne de données (DL3) et l'une, correspondante, de multiples troisièmes diodes organiques d'émission de lumière (OLED) ayant un troisième rendement d'émission inférieur au deuxième rendement d'émission et chaque troisième pixel (B) étant conçu pour émettre une lumière correspondant à un signal de données stocké de façon capacitive dans le troisième, correspondant, des premiers condensateurs (Cst), et

un troisième des multiples seconds condensateurs (Cdata1, Cdata2, Cdata3), connecté à la troisième ligne de données (DL3) et ayant une troisième capacité inférieure à la deuxième capacité,

dans lequel chaque première diode organique d'émission de lumière (OLED) est une diode organique d'émission de lumière verte, chaque deuxième diode organique d'émission de lumière (OLED) est une diode organique d'émission de lumière rouge et chaque troisième diode organique d'émission de lumière (OLED) est une diode organique d'émission de lumière bleue.

3. Dispositif organique d'affichage à émission de lumière selon la revendication 2, dans lequel le premier des multiples deuxièmes condensateurs (Cdata2) est formé par une première zone de chevauchement plus grande qu'une deuxième zone de chevauchement formant le deuxième des multiples seconds condensateurs (Cdata1), et dans lequel une troisième zone de chevauchement formant le troisième des multiples deuxièmes condensateurs (Cdata3) est plus petite que la deuxième zone de chevauchement.

4. Dispositif organique d'affichage à émission de lumière selon la revendication 3, dans lequel la première ligne de données (DL2), reliée aux premiers multiples pixels (G), chevauche la ligne (210) de source d'énergie sur une première largeur (w2), et la deuxième ligne de données (DL1), reliée aux deuxièmes multiples pixels (R), chevauche la ligne de source d'énergie (210) d'une deuxième largeur (w1) plus petite que la première largeur (w2).

5. Dispositif organique d'affichage à émission de lumière selon l'une des revendications 3 et 4, dans lequel la première ligne de données (DL2), reliée aux premiers multiples pixels (G), chevauche la ligne de source d'énergie sur une première longueur (h2), et la deuxième ligne de données (DL1), reliée aux deuxièmes multiples pixels (R), chevauche la ligne de source d'énergie (210) sur une seconde longueur (h1) plus courte que la première longueur (h2).

6. Dispositif organique d'affichage à émission de lumière selon la revendication 5, dans lequel la troisième ligne de données (DL3), reliée aux troisièmes multiples pixels (B), chevauche la ligne (202) de source d'énergie sur une troisième longueur (h3) plus courte que la deuxième longueur (h1).

7. Dispositif organique d'affichage à émission de lumière selon la revendication 4 ou les revendications 4 et 5, dans lequel la troisième ligne de données (DL3), reliée aux troisièmes multiples pixels (B), chevauche la ligne (210) de source d'énergie sur une troisième largeur (w3) inférieure à la deuxième largeur (w1).

8. Dispositif organique d'affichage à émission de lumière selon la revendication 1, dans lequel l'unité d'attaque de balayage (110) est conçue pour fournir le signal de balayage (SS) pendant une première période (SCAN PERIOD) d'une période horizontale (1H), et l'unité d'attaque de données (120) est conçue pour fournir les signaux de données (R, G, B) aux lignes de sortie (D1...Dm/i) pendant une seconde période (DATA PERIOD) de la même période horizontale (1H) à l'exclusion de la première période (SCAN PERIOD).

9. Dispositif organique d'affichage à émission de lumière selon la revendication 1, dans lequel chaque démultiplexeur (162) comporte de multiples transistors (T1, T2, T3), chaque transistor (T1, T2, T3) étant relié à l'une des multiples lignes de données (D1...Dm/i).

10. Dispositif organique d'affichage à émission de lumière selon la revendication 9, dans lequel les multiples transistors (T1, T2, T3) sont débloqués séquentiellement, et le premier des multiples seconds condensateurs (Cdata2), le deuxième des multiples seconds condensateurs (Cdata1) et le troisième des multiples seconds condensateurs (Cdata3) sont chargés avec des tensions correspondant aux signaux de données (R, G, B) lorsque les transistors (T1, T2, T3) sont débloqués.

11. Dispositif organique d'affichage à émission de lumière selon la revendication 10, dans lequel les tensions stockées dans le premier des multiples seconds condensateurs (Cdata2), le deuxième des multiples seconds condensateurs (Cdata1) et le troisième des multiples condensateurs (Cdata3) sont fournis aux multiples premiers pixels (G), aux multiples deuxièmes pixels (R) et aux multiples troisièmes pixels (B) pendant la première période (SCAN PERIOD).

12. Dispositif organique d'affichage à émission de lumière selon l'une quelconque des revendications précédentes, comportant en outre :

un substrat (300) ;
une partie à plots (200) formée sur le substrat (300), la partie à plots (200) ayant des premiers plots (Ps), des deuxièmes plots (Pd), des troisièmes plots (Pvdd1), des quatrièmes plots (Pvdd2), des cinquièmes plots (Pvss) et des sixièmes plots (Pc) ;

dans lequel l'unité d'attaque de balayage (110) est située sur un côté de la partie de pixels (130) et est reliée électriquement aux premiers plots (Ps) et aux lignes de balayage (S1...Sn) ; et l'unité d'attaque de données (120) est formée directement sur le substrat (300) ou encastrée sous la forme d'une puce sur le substrat (300) et est reliée électriquement à une ligne de source d'énergie auxiliaire (212), aux deuxièmes plots (Pd) et à la première ligne de données (DL2) ;

la première ligne (210) de source d'énergie est placée de façon à être adjacente à tous les côtés de la partie de pixels (130) le long de bords du substrat (300) à l'exception de l'emplacement où la partie à plots (200) est située et est reliée aux troisièmes plots (Pvdd1) et aux lignes (VDD) de source d'énergie de pixels ;
la ligne (212) de source d'énergie auxiliaire est située sur le substrat (300) le long d'un bord où se trouve la partie à plots (200) et est reliée aux quatrièmes plots (Pvdd2) et aux multiples lignes (VDD) de source d'énergie de pixels ;
une seconde ligne (230) de source d'énergie est formée sur le substrat (300), reliée aux cinquièmes plots (Pvss) et à chacun des pixels (R, G, B) ; et
un bloc démultiplexeur (160) est relié à la première ligne de données (DL2), à la deuxième ligne de données (DL1) et aux sixièmes plots (Pc).

13. Dispositif organique d'affichage à émission de lumière selon la revendication 12, dans lequel l'unité d'attaque de données (120) et le bloc démultiplexeur (160) sont encastrés sur un circuit imprimé souple relié au substrat (300), et dans lequel l'unité d'attaque de données (120) et le bloc démultiplexeur (160) sont reliés électriquement à la deuxième ligne de données (DL1) par l'intermédiaire de la partie à plots (200) du substrat (300).

# FIG. 1
# (PRIOR ART)

FIG. 2

# FIG. 3

# FIG. 4

# FIG. 5

# FIG. 6

EP 1 647 967 B1

# FIG. 7

1000

A

140

230

130

210

300

110

S  E

DL

VDD

160

212

120

D

Pvdd1  Ps  Pvdd2  Pd   Pvdd2   Pvdd1

Pc                              Pvss

200

# FIG. 8

A1

210

h1

h2

h3

...

Cdata1
R

Cdata2
G

Cdata3
B

...

Cdata1
R

Cdata2
G

Cdata3
B

DL1
(DLR)

DL2
(DLG)

DL3
(DLB)

DLm−2
(DLR)

DLm−1
(DLG)

DLm
(DLB)

# FIG. 9

# FIG. 10

# FIG. 11

B1

210

· · ·

DL1  DL2  DL3  DL4  DL5     DLm-4     DLm-2     DLm
                              DLm-3     DLm-1

# FIG. 12

B2

W4  W5     W5  W4  W3

W1  W2  W3                    W2  W1

210

· · ·

DL1  DL2  DL3  DL4  DL5     DLm-4     DLm-2     DLm
                              DLm-3     DLm-1

FIG. 13

B3

210

. . .

DL1  DL2  DL3  DL4  DL5    DLm-4    DLm-2    DLm

DLm-3    DLm-1

# FIG. 14

3000

B

140

110

212

230

130

210

300'

S    E

DL

VDD

R G B R    B R G B

R G B R    B R G B

R G B R    B R G B

R G B R    B R G B

R G B R    B R G B

R G B R    B R G B

160'

120'

180

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6448718 B1